(19) Europäisches Patentamt
European Patent Office
Office européen des brevets

(11) **EP 3 022 594 B1**

(12) **FASCICULE DE BREVET EUROPEEN**

(45) Date de publication et mention de la délivrance du brevet:
**03.04.2019 Bulletin 2019/14**

(21) Numéro de dépôt: **14739416.7**

(22) Date de dépôt: **11.07.2014**

(51) Int Cl.:
**G02B 6/124** *(2006.01)*

(86) Numéro de dépôt international:
**PCT/EP2014/064994**

(87) Numéro de publication internationale:
**WO 2015/007664 (22.01.2015 Gazette 2015/03)**

(54) **COUPLEUR OPTIQUE MUNI D'UNE STRUCTURATION**

OPTISCHER KOPPLER MIT EINER STRUKTURIERUNG

OPTICAL COUPLER PROVIDED WITH A STRUCTURATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.07.2013 FR 1356953**

(43) Date de publication de la demande:
**25.05.2016 Bulletin 2016/21**

(73) Titulaires:
• **Commissariat à l'Energie Atomique et aux Energies Alternatives**
**75015 Paris (FR)**
• **Alcatel Lucent**
**91620 Nozay (FR)**

(72) Inventeurs:
• **BOUTAMI, Salim**
**F-38100 Grenoble (FR)**
• **BRUN, Mickaël**
**F-38320 Eybens (FR)**
• **LABEYE, Pierre**
**F-38000 Grenoble (FR)**
• **NICOLETTI, Sergio**
**F-38650 Sinard (FR)**
• **MAISONS, Grégory**
**F-91460 Marcoussis (FR)**

(74) Mandataire: **Lavoix**
**2, place d'Estienne d'Orves**
**75441 Paris Cedex 09 (FR)**

(56) Documents cités:
WO-A1-02/44780    FR-A1- 2 909 491
US-A1- 2011 194 804    US-A1- 2011 299 561

• Przemek J. Bock ET AL: "Subwavelength grating periodic structures in silicon-on-insulator: a new type of microphotonic waveguide", Optics Express, vol. 18, no. 19, 13 September 2010 (2010-09-13), page 20251, XP055410281, ISSN: 2161-2072, DOI: 10.1364/OE.18.020251

**Description**

La présente invention concerne un coupleur optique, un composant comprenant un tel coupleur optique, un procédé de détermination et un procédé de fabrication d'un tel coupleur optique.

L'invention se situe dans le domaine de l'intégration hétérogène de sources lasers sur une structure optique intégrée. De telles intégrations trouvent des applications dans différents domaines utilisant les composants de la photonique intégrée. Parmi les applications, il existe les télécommunications optiques, les capteurs optiques ou la biophotonique. Pour ces différentes applications, il existe un besoin pour des structures permettant de guider efficacement la lumière.

La photonique intégrée s'est développée sur des substrats comme le verre, le silicium ou les matériaux III-V. On rappelle qu'un semi-conducteur de type « III - V » est un semi-conducteur composite fabriqué à partir d'un ou plusieurs éléments de la colonne III du tableau périodique des éléments (bore, aluminium, gallium, indium, ...) et d'un ou plusieurs éléments de la colonne V ou pnictogènes (azote, phosphore, arsenic, antimoine ...). Il est souhaitable d'utiliser plutôt des substrats en silicium puisque les substrats en silicium permettent d'intégrer à la fois des composants optiques et des composants électroniques.

Toutefois, il n'existe pas encore de source laser monolithique efficace sur silicium. Pour pallier ce problème, ce sont des intégrations hétérogènes de source laser utilisant des matériaux III-V sur un substrat silicium qui sont généralement utilisées.

Pour obtenir un couplage efficace de la lumière laser créée par la source laser dans le matériau III-V avec la structure guidante en silicium, il a été proposé de coupler, par des ondes évanescentes, un guide d'ondes passif de la structure guidante en silicium avec la source laser. Le couplage est lié au rapport entre l'amplitude du champ électrique de l'onde circulant dans le guide d'ondes passif et l'amplitude du champ électrique de l'onde émis par la source laser. Plus précisément, le couplage est défini par la formule $C=I2/(I1+I2)$, où $C$ est le couplage, $I1$ est l'intensité du champ électrique dans le laser et $I2$ l'intensité du champ électrique dans le guide d'ondes passif. Par ailleurs, on rappelle qu'un guide d'ondes passif est un guide d'ondes dépourvu d'élément actif.

L'obtention du couplage entre la source laser et le guide d'ondes passif impose que la source laser soit très proche du guide d'ondes passif. Le couplage dépend en effet fortement de l'espacement entre la source laser et le guide d'ondes passif. Cette proximité est souvent difficile à obtenir en pratique puisqu'il convient de protéger le guide d'ondes passif par le dépôt d'une couche isolante dégradant la source laser, notamment à cause de la température à laquelle est réalisé le dépôt.

Pour contourner ce problème, il est proposé dans le document WO-A-03/054 596 de réaliser un guide d'ondes passif comportant un relief optique à efficacité graduelle.

Toutefois, ce type de structure est difficile à réaliser dans une technologie impliquant du silicium.

Un coupleur optique selon le préambule de la revendication 1 est connu de document FR 2 909 491 A. D'autres types de coupleurs optiques sont connus des documents WO 02/44780 A, US 2011/0299561 A et US 2011/194804 A1 ainsi que l'article de Bock et al. intitulé « Subwavelength grating periodic structures in silicon-on-insulator : a new type of microphonic waveguide ».

Il existe donc un besoin pour un coupleur optique présentant une bonne efficacité de couplage et dont la fabrication soit plus aisée.

A cet effet, l'invention a pour objet un coupleur optique selon la revendication 1.

Un tel coupleur optique permet d'obtenir un meilleur couplage. Le coupleur optique est aisé à fabriquer puisque seules des techniques issues de la microélectronique sont employées.

Suivant des modes de réalisation particuliers, le coupleur optique comprend une ou plusieurs des caractéristiques suivantes, prise(s) isolément ou suivant toutes les combinaisons techniquement possibles :

- les structures sont choisies dans le groupe constitué par des ouvertures réalisées dans le deuxième guide d'ondes et des lamelles.
- les structures présentent une dimension le long de la direction transversale supérieure à la dimension du coeur du deuxième guide d'ondes le long de la direction transversale.
- le coeur du deuxième guide d'ondes présentant un indice optique, le deuxième indice effectif est supérieur au premier indice effectif et les structures sont réalisées dans un matériau présentant un indice optique inférieur à l'indice optique du coeur du deuxième guide d'onde.
- la structuration présente un facteur de remplissage, les structures sont réalisées dans un matériau présentant un indice optique, lesdits paramètres influant sur le couplage par ondes évanescentes entre le premier guide d'ondes et le deuxième guide d'ondes étant le facteur de remplissage de la structuration, l'indice optique du matériau dans lequel les structures sont réalisées et l'espacement le long de la direction longitudinale entre chaque structure.
- chaque guide d'ondes comporte une gaine et un coeur, l'indice optique du coeur du premier guide d'ondes étant inférieur à l'indice optique de la gaine du deuxième guide d'ondes.
- l'espacement le long de la direction longitudinale entre les structures est variable le long de la direction longitudinale.
- le premier guide d'ondes comporte un coeur réalisé dans un matériau appartenant à la colonne III du tableau périodique composé avec un matériau selon la colonne V du tableau périodique et deux couches inférieure et supérieure entourant le coeur.

- le coeur du deuxième guide d'ondes présente une dimension variable le long de la direction transversale.
- le coupleur optique comporte un troisième guide d'ondes distinct des premier et deuxième guides d'ondes et s'étendant parallèlement aux premier et deuxième guides d'ondes, le troisième guide d'ondes étant agencé entre le premier guide d'ondes et le deuxième guide d'ondes et étant propre à propager un troisième mode de propagation de lumière présentant un troisième indice effectif.
- une zone d'isolation thermique du premier guide d'ondes dans laquelle la structuration est agencée.

L'invention concerne aussi un composant optique comportant un coupleur optique tel que précédemment décrit.

En outre, la présente invention a également pour objet un procédé de détermination d'un coupleur optique selon la revendication 13.

Par ailleurs, la présente invention se rapporte aussi à un procédé de fabrication d'un coupleur optique selon la revendication 14.

Le procédé de fabrication permet d'obtenir le coupleur optique précédemment décrit avec uniquement des techniques issues de la microélectronique. De telles techniques sont de mise en oeuvre particulièrement aisée.

D'autres caractéristiques et avantages de l'invention apparaîtront à la lecture de la description qui suit de modes de réalisation de l'invention, donnés à titre d'exemple uniquement et en référence aux dessins qui sont :

- figure 1, une vue schématique en coupe d'un exemple de coupleur optique selon un premier mode de réalisation de l'invention ;
- figure 2, une cartographie du champ électrique dans le coupleur optique selon la figure 1 en fonctionnement,
- figure 3, un graphique présentant l'évolution spatiale de la répartition du couplage dans les différents guides d'ondes pour le coupleur optique selon la figure 1,
- figure 4, une cartographie du champ électrique dans un coupleur optique selon l'état de la technique,
- figure 5, un graphique présentant l'évolution spatiale de la répartition du couplage dans les différents guides d'ondes pour le coupleur optique selon l'état de la technique considéré à la figure 4,
- figures 6 à 11, des représentations schématiques en coupe de l'élément obtenu à différents stades de la mise en oeuvre du procédé de fabrication du coupleur optique selon le premier mode de réalisation illustrée par la figure 1,
- figure 12, une cartographie du champ électrique dans le coupleur optique selon un deuxième mode de réalisation de l'invention en fonctionnement,

- figure 13, un graphique présentant l'évolution spatiale de la répartition du couplage dans les différents guides d'ondes pour le coupleur optique selon la figure 12,
- figure 14, une vue schématique en coupe d'un exemple de coupleur optique selon un troisième mode de réalisation de l'invention, et
- figure 15, une vue schématique en coupe d'un exemple de coupleur optique selon un quatrième mode de réalisation de l'invention.

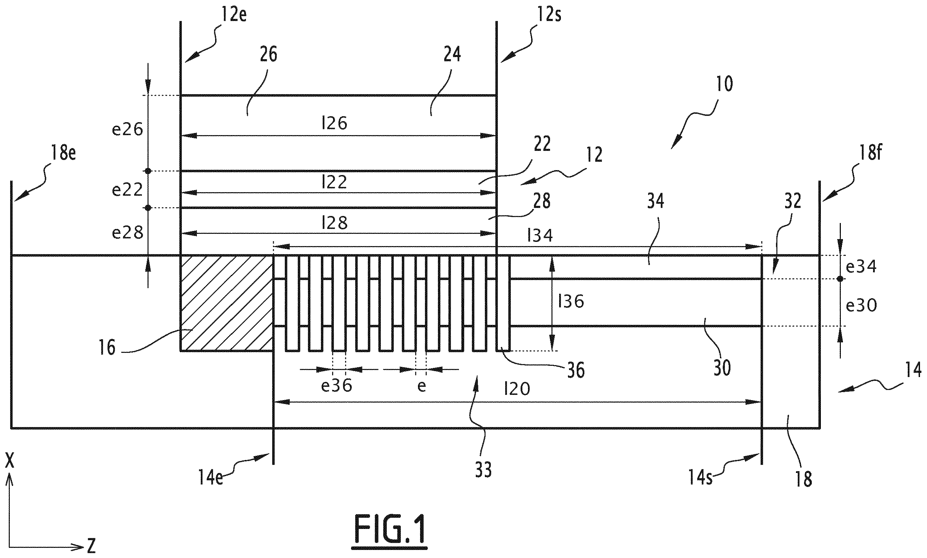

Dans le cadre de l'invention, il est proposé un coupleur 10 optique propre à fonctionner pour une longueur d'onde À tel que représenté sur la figure 1

Ce coupleur 10 est dans une configuration verticale, c'est-à-dire une configuration dans laquelle ce coupleur optique 10 est propre à coupler de la lumière entre deux guides décalés dans une direction transversale perpendiculaire à une direction générale de la propagation de la lumière.

Le coupleur 10 comprend un premier guide d'ondes 12 s'étendant selon une direction longitudinale Z et propre à propager un premier mode de propagation P1 de la lumière présentant un premier indice effectif NF1. En effet, selon la répartition de champ, chaque mode de propagation voit un indice différent des matériaux constituant le guide d'ondes dépendant de chaque mode de propagation. L'indice vu par chaque mode de propagation définit l'indice effectif.

Le coupleur 10 comprend également un deuxième guide d'ondes 14 distinct du premier guide d'ondes 12. Le deuxième guide d'ondes 14 est parallèle au premier guide d'ondes 12. Le deuxième guide d'ondes 14 présente un coeur 30 et une gaine 32. En outre, le deuxième guide d'ondes 14 est propre à propager un deuxième mode de propagation P2 de la lumière présentant un deuxième indice effectif NF2. Le deuxième indice effectif NF2 est différent du premier indice effectif NF1.

Le deuxième guide d'ondes 14 présente une structuration 33 sous forme d'une succession de structures 36. La structuration 33 peut également être désignée sous le terme générique de réseau 33. Toutefois, dans un souci de clarté, ce terme n'est pas utilisé dans le cadre de cette description puisque la structuration 33 n'est pas un réseau de diffraction. Notamment, la structuration 33 n'a pas pour fonction d'amplifier le champ dans le milieu à gain. Au contraire, la structuration 33 permet d'extraire de la lumière par modification de l'indice effectif.

Les structures 36 s'étendent selon le long d'une direction transversale X perpendiculaire à la direction longitudinale Z. Les structures sont parallèles entre elles et orthogonales à la direction générale du premier guide d'ondes. La structuration 33 présente une période P le long de la direction longitudinale Z inférieure au rapport entre la longueur d'onde λ à laquelle est propre à fonctionner le coupleur optique 10 et le produit de deux par le deuxième indice effectif NF2. Par définition, la période P est la somme de l'espacement entre deux structures 36 et la largeur d'une structure 36.

Les structures 36 présentent des paramètres influant sur le couplage C par ondes évanescentes entre le premier guide d'ondes 12 et le deuxième guide d'ondes 14, ces paramètres étant choisis de sorte que le couplage C soit supérieur à 15%.

Pour rappel, dans le cadre de l'invention, il est choisi d'exprimer le couplage comme le rapport entre l'intensité du champ électrique de l'onde circulant dans le deuxième guide d'ondes 14 et la somme des intensités des champs électriques de l'onde circulant dans le premier guide d'ondes 12 et le deuxième guide d'ondes 14. Dans la suite, le couplage ainsi défini est noté « C » qui est un nombre sans unité.

Lorsque le premier guide d'ondes 12 est alimenté en énergie, le premier guide d'ondes 12 émet de la lumière sous forme d'ondes guidées.

Une partie des ondes guidées dans le premier guide d'ondes 12 se couple alors avec le deuxième guide d'ondes 14 par des ondes évanescentes. Des ondes sont alors guidées dans le deuxième coeur 30.

La structuration 33 permet de réaliser une adaptation de l'indice effectif favorisant le couplage entre le premier guide d'ondes 12 et le deuxième guide d'ondes 14.

Ce meilleur couplage s'obtient tout en conservant une fabrication aisée. En effet, il peut être utilisé un procédé de fabrication avec uniquement des techniques issues de la microélectronique. Un tel procédé de fabrication comprend des étapes de fabrication des guides d'ondes 12, 14 et de la structuration 33 impliquant des techniques de dépôt, d'épitaxie, de polissage, de collage, et d'enlèvement de matière par gravure.

Les structures 36 sont par exemple des ouvertures réalisées dans le deuxième guide d'ondes 14. Selon les modes de réalisation, ces ouvertures ont une forme carrée ou ronde. En variante, les ouvertures ont une forme de fente, l'intérieur de la fente étant du vide ou de l'air.

Selon un autre exemple, les structures 36 sont des lamelles telles que représentées à la figure 1.

De préférence, les structures 36 présentent une dimension le long de la direction transversale X supérieure à la dimension du coeur 30 du deuxième guide d'ondes 14 le long de la direction transversale X. Cette propriété permet d'augmenter le couplage.

Selon un mode de réalisation, le deuxième indice effectif NF2 est supérieur au premier indice effectif NF1, les structures 36 sont alors réalisées dans un matériau présent un indice optique inférieur à l'indice optique du coeur 30 du deuxième guide d'onde 14. Cela permet de faciliter l'obtention d'un meilleur couplage.

Lorsque le deuxième indice effectif NF2 est inférieur au premier indice effectif NF1, les structures 36 sont alors réalisées dans un matériau présentant un indice optique supérieur à l'indice optique du coeur 20 du deuxième guide d'onde 14. Cela permet de faciliter l'obtention d'un meilleur couplage.

Avantageusement, chaque paramètre caractérisant la structuration 33 est un paramètre influant sur le couplage C par ondes évanescentes entre le premier guide d'ondes 12 et le deuxième guide d'ondes 14.

Ainsi, dans le cas où la structuration 33 présente un facteur de remplissage F et les structures 36 sont réalisées dans un matériau présentant un indice optique, lesdits paramètres influant sur le couplage C par ondes évanescentes entre le premier guide d'ondes 12 et le deuxième guide d'ondes 14 sont le facteur de remplissage de la structuration 33, l'indice optique du matériau dans lequel les structures 36 sont réalisées et l'espacement e le long de la direction longitudinale Z entre chaque structure 36.

Dans ces conditions, au premier ordre, le nouvel indice effectif NF2' du mode du guide avec structuration est donné par $NF2' = F * n36 + (1 - F)* NF2$ et la relation $NF2' \approx NF1$ est également vérifiée.

De préférence pour augmenter le couplage, l'espacement e le long de la direction longitudinale Z entre les structures 36 est variable le long de la direction longitudinale Z.

Dans un mode de réalisation particulier, le premier guide d'ondes 12 comporte un coeur 22 réalisé dans un matériau appartenant à la colonne III du tableau périodique composé avec un matériau selon la colonne V du tableau périodique et deux couches inférieure 26 et supérieure 28 entourant le coeur 20.

Avantageusement, pour favoriser le couplage, le coeur 30 du deuxième guide d'ondes 14 présente une dimension variable le long de la direction transversale X.

Pour isoler le deuxième guide d'ondes 14 de l'environnement du premier guide d'ondes 12, selon un mode de réalisation avantageux, le coupleur optique 10 comporte un substrat 18, formé dans un premier matériau, dans lequel le deuxième guide d'ondes 14 est enfoui, le premier guide d'ondes 12 étant agencé en contact avec le substrat 18 et formé dans un matériau différent du premier matériau.

Pour augmenter cet effet d'isolation de l'environnement, le coupleur optique 10 comporte un troisième guide d'ondes distinct des premier et deuxième guides d'ondes 12, 14 et s'étendant parallèlement aux premier et deuxième guides d'ondes 12, 14, le troisième guide d'ondes étant agencé entre le premier guide d'ondes 12 et le deuxième guide d'ondes 14 et étant propre à propager un troisième mode de propagation P3 de lumière présentant un troisième indice effectif NF3.

Selon une variante, le coupleur optique 10 comporte une zone d'isolation thermique du premier guide d'ondes 12 dans laquelle la structuration 33 est agencé. Cela permet d'assurer une bonne gestion de la thermique du premier guide d'ondes 12 et notamment d'éviter son échauffement.

Dans la suite, des modes de réalisation particuliers sont décrits plus précisément. C'est notamment le cas du coupleur optique 10 de la figure 1.

Pour la suite de la description, il est défini une direction longitudinale correspondant à une direction générale de propagation de la lumière. Il est également défini une direction transversale perpendiculaire à la direction longitudinale et contenue dans le plan de la figure 1. Les directions longitudinale et transversale sont respectivement symbolisées par un axe Z et un axe X sur la figure 1.

En outre, lorsque le terme « indice » est utilisé pour un milieu, ce terme renvoie à l'indice de réfraction de ce milieu, qui est une grandeur sans dimension caractéristique de ce milieu et décrivant le comportement de la lumière dans ce milieu. Dans le cas où le milieu est à gradient d'indice, le terme « indice » renvoie à la moyenne de l'indice dans ce milieu.

On a représenté sur la figure 1 un coupleur optique 10, comportant un premier guide d'ondes 12, un deuxième guide d'ondes 14 et un élément d'isolation 16. Le coupleur optique 10 comprend également un substrat 18 dans lequel le deuxième guide d'ondes 14 est enfoui, le premier guide d'ondes 12 reposant sur le substrat 18.

Le coupleur optique 10 est propre à coupler de la lumière du premier guide d'ondes 12 vers le deuxième guide d'ondes 14.

Dans ce qui suit, on appelle « configuration verticale » une configuration dans laquelle le coupleur optique est propre à coupler de la lumière entre deux guides décalés dans la direction transversale X. Par opposition, on appelle « configuration horizontale », une configuration dans laquelle le coupleur optique est propre à coupler de la lumière entre deux guides alignés le long de la direction transversale X. Dans l'exemple de la figure 1, le coupleur optique 10 est dans une configuration verticale.

Le premier guide d'ondes 12 s'étend selon la direction longitudinale Z entre un premier plan d'entrée 12e et un premier plan de sortie 12s. Chaque premier plan 12e et 12s est un plan perpendiculaire à la direction longitudinale Z.

Le premier guide d'ondes 12 comporte un premier coeur 22 et une première gaine 24.

Le premier coeur 22 est formé par une couche s'étendant le long de la direction longitudinale Z. Le premier coeur 22 présente une dimension e22 le long de la direction transversale X de 1,5 micron (μm) et une dimension l22 le long de la direction longitudinale Z peut être de plusieurs millimètres, mais sa dimension le long d'une zone de couplage définie par le recouvrement avec le deuxième coeur 30 est typiquement de l'ordre de 100 μm..

Le premier coeur 22 est, par exemple, une hétérostructure formée à partir d'un premier matériau qui est un mélange composé d'Arsenic, d'Indium, et d'Aluminium (de formule AlInAs) et d'un deuxième matériau qui est un mélange composé d'Arsenic, d'Indium, et de Gallium (de formule GaInAs). De ce qui suit, l'indice nc1 du premier coeur 22 vaut 3,3, ce qui se traduit mathématiquement par nc1 = 3,3.

Plus généralement, le premier coeur 22 est dans un matériau à gain, c'est-à-dire un matériau propre à générer de l'émission stimulée de photons suite à une excitation.

La première gaine 24 présente une première couche supérieure 26 et une première couche inférieure 28, le premier coeur 22 étant agencé entre la première couche supérieure 26 et la première couche inférieure 28.

La première couche supérieure 26 présente une dimension e26 le long de la direction transversale X de 1 μm et une dimension l26 le long de la direction longitudinale Z de l'ordre de 100 μm.

La première couche inférieure 28 présente une dimension e28 le long de la direction transversale X de 0,5 μm et une dimension l28 le long de la direction longitudinale Z de l'ordre de 100 μm.

Selon l'exemple de la figure 1, la première couche supérieure 26 et la première couche inférieure 28 sont réalisées dans le même matériau. Ce matériau est le matériau dans lequel est réalisée la première gaine 24.

Dans le cas illustré, le matériau est du phosphore d'indium.

En variante, la première couche supérieure 26 et la première couche inférieure 28 sont réalisées dans deux matériaux différents.

L'indice ng1 de la première gaine 24 vaut alors 3,1, ce qui se traduit mathématiquement par ng1 = 3,1.

Le premier guide d'ondes 12 forme un guide d'ondes actif. On entend par « guide d'ondes actif » un guide d'ondes comportant au moins une couche formée en matériau actif propre à générer une onde. Dans le cas de la figure 1, le premier coeur 22 est une telle couche.

Plus précisément, le premier guide d'ondes 12 est un guide d'ondes laser, c'est-à-dire une source laser. Le premier guide d'ondes 12 est, par exemple, une source laser dite à cascade quantique (plus souvent désigné par son acronyme anglais de QCL). Un tel guide d'ondes 12 est propre à générer des ondes laser à une longueur d'onde de 4,5 μm.

Le premier guide d'ondes 12 est propre à propager les ondes selon un premier mode de propagation P1 correspondant à un premier indice effectif NF1. En effet, selon la répartition de champ, chaque mode de propagation voit un indice différent des matériaux constituant le guide d'ondes dépendant de chaque mode de propagation. L'indice vu par chaque mode de propagation définit l'indice effectif. Dans le cas présent, le premier indice effectif NF1 est égal à 3,21.

Le deuxième guide d'ondes 14 s'étend selon la direction longitudinale Z entre un deuxième plan d'entrée 14e et un deuxième plan de sortie 14s. Chaque deuxième plan 14e et 14s est un plan perpendiculaire à la direction longitudinale Z. Le deuxième plan d'entrée 14e est positionné entre le premier plan d'entrée 12e et le premier plan de sortie 12s.

Le deuxième guide d'ondes 14 comporte un deuxième coeur 30, une deuxième gaine 32 et une structuration 33.

Le deuxième coeur 30 est formé par une couche s'étendant le long da la direction longitudinale Z. Le deuxième coeur 30 présente une dimension e30 le long da la direction transversale X de 1,5 μm et une dimension l30 le long de la direction longitudinale Z est de plusieurs millimètres. Toutefois, sa dimension le long de la direction longitudinale Z le long de la zone de recouvrement avec le premier coeur est de l'ordre de 100 μm.

Le deuxième coeur 30 est, par exemple, réalisé en silicium-germanium. De ce fait, l'indice nc2 du deuxième coeur 30 vaut 3,6, ce qui se traduit mathématiquement par nc2 = 3,6.

La deuxième gaine 32 comporte une deuxième couche supérieure 34 et une deuxième couche inférieure confondue avec le substrat 18.

En variante, la deuxième gaine 32 comprend une deuxième couche inférieure distincte du substrat 18.

La deuxième couche supérieure 34 présente une dimension e34 le long de la direction transversale X de 0,75 μm et une dimension l34 le long de la direction longitudinale Z peut être de plusieurs millimètres ou centimètres. Toutefois, sa dimension le long de la direction longitudinale le long de la zone de couplage définie par le recouvrement avec le deuxième coeur 30 est de l'ordre de 100 μm.

La deuxième gaine 32 est, par exemple, réalisée en silicium. L'indice ng2 de la deuxième gaine 32 vaut alors 3,4, ce qui se traduit mathématiquement par ng2 = 3,4.

Le deuxième guide d'ondes 14 est un guide d'ondes passif, c'est-à-dire un guide d'ondes ne comportant pas de couche formé dans un matériau actif.

Le deuxième guide d'ondes 14 est propre à permettre la propagation d'un deuxième mode de propagation noté P2 correspondant à un deuxième indice effectif NF2. En l'absence dde la structuration 33, le deuxième indice effectif NF2 est supérieur au premier indice effectif NF1. Dans ce cas, le deuxième indice effectif NF2 est égal à 3,51, ce qui se traduit mathématiquement par NF2 = 3,51.

En variante, le premier guide d'ondes 12 présente un premier indice effectif NF1 supérieur au deuxième indice effectif NF2. Seul le cas où le premier indice effectif NF1 est inférieur au deuxième indice effectif NF2 est considéré, la transposition étant aisée pour l'homme du métier.

Le deuxième guide d'ondes 14 est enfoui dans le substrat 18, c'est-à-dire qu'il est isolé optiquement du milieu environnant.

L'élément d'isolation 16 est, selon l'exemple de la figure 1, un élément d'isolation optique se présentant sous la forme d'un élément parallélépipédique. Dans la vue en coupe de la figure 1, il s'étend le long de la direction longitudinale Z entre le premier plan d'entrée 12e et le deuxième plan d'entrée 14e.

L'élément d'isolation 16 est réalisé dans un matériau dont l'indice est inférieur à l'indice effectif NF1 du premier guide d'ondes 12.

L'emploi de l'élément d'isolation 16 permet d'éviter le couplage par ondes évanescentes entre le premier guide d'ondes 12 et le substrat 18.

Le substrat 18 est formé par une couche s'étendant le long de la direction longitudinale Z s'étendant entre un plan d'entrée 18e et un plan de sortie 18f. Selon l'exemple de la figure 1, ledeuxième plan de sortie 14s est situé entre le premier plan de sortie 12s et le plan de sortie 18f du substrat 18 tandis que le premier plan d'entrée 12e est entre le plan d'entrée 18e du substrat 18 et le premier plan de sortie 12s.

Le substrat 18 présente une dimension e18 le long de la direction transversale X de l'ordre de plusieurs centaines de μm d'épais, par exemple 700 μm et une dimension l18 le long de la direction longitudinale Z de plusieurs dizaines de centimètres de large.

Le substrat 18 est, par exemple, réalisé en silicium. L'indice ns18 du substrat 18 vaut alors 3,4, ce qui se traduit mathématiquement par ns18 = 3,4.

La structuration 33 est une succession de lamelles 36.

Chaque lamelle 36 s'étend selon une direction transversale X.

Selon l'exemple de la figure 1, chaque lamelle 36 se présente sous la forme d'un parallélépipède.

Chaque lamelle 36 est parallèle aux autres lamelles 36.

Chaque lamelle 36 est agencée à la fois dans le deuxième coeur 30 et dans la deuxième gaine 32 et dans le substrat 18.

Chaque lamelle 36 présente une dimension l36 le long de la direction transversale X et une dimension e36 le long de la direction longitudinale Z.

La structuration 33 présente un espacement e entre les lamelles 36 le long de la direction longitudinale Z.

La structuration 33 présente également un facteur de remplissage correspondant au rapport entre la dimension e36 le long de la direction longitudinale Z et la somme de la dimension e36 le long de la direction longitudinale Z et de l'espacement e entre les lamelles 36 le long de la direction longitudinale Z.

L'indice du matériau dans lequel sont réalisées les lamelles 36 est noté n36. L'indice n36 des lamelles 36 est inférieur à l'indice effectif NF1 du premier guide d'ondes 16.

Il apparaît que la structuration 33 est caractérisée par une pluralité de paramètres qui sont pour l'espacement e entre les lamelles 36 le long de la direction transversale X, le facteur de remplissage et l'indice du matériau dans lequel les lamelles 36 sont réalisées. Les paramètres qui caractérisent la structuration 33 sont des paramètres influençant le couplage entre le premier guide d'ondes 12 et le deuxième guide d'ondes 14.

En variante, d'autres paramètres sont utilisés pour caractériser la structuration 33. Notamment, une combinaison linéaire des paramètres précédents est intéressante.

A titre d'exemple, au lieu d'utiliser la dimension précitée, il est utilisé une pluralité de dimensions, à savoir la dimension des lamelles 36 dans la deuxième couche supérieure 34 le long de la direction transversale X, la dimension des lamelles 36 dans le deuxième coeur 30 le long de la direction transversale X et la dimension des lamelles 36 dans la deuxième couche inférieure le long de la direction transversale X.

Selon une variante, au lieu du facteur de remplissage, il est utilisé la dimension selon la direction longitudinale Z des lamelles 36.

Les paramètres caractérisant chaque lamelle 36 vérifient une première propriété notée P1. La première propriété P1 est vérifiée lorsque le couplage par ondes évanescentes entre le premier guide d'ondes 12 et le deuxième guide d'ondes 14 est supérieur à 15%. Pour rappel, dans le cadre de l'invention, il est choisi d'exprimer le couplage comme le rapport entre l'intensité du champ électrique de l'onde circulant dans le deuxième guide d'ondes 14 et la somme des intensités des champs électriques de l'onde circulant dans le premier guide d'ondes 12 et le deuxième guide d'ondes 14. Dans la suite, le couplage ainsi défini est noté « C » qui est un nombre sans unité.

De manière connue en soi, pour un couplage par ondes évanescentes imposé, l'homme du métier est capable de déterminer un deuxième guide d'ondes équivalent au deuxième guide d'ondes 14 muni de la structuration 33. Déterminer les paramètres manquants dde la structuration 33 revient donc à déterminer les caractéristiques optimales du deuxième guide d'ondes équivalent. L'indice effectif du mode du guide d'onde 14 muni de la structuration 33 est alors au premier ordre donné par la relation :

$$NF2 = F * n36 + (1 - F) * NF2'$$

où :

- F est le facteur de remplissage de la structuration 33.
- NF2' est l'indice effectif du mode de propagation du guide d'onde 14 sans structuration (sans structuration 33)

Or, l'optimisation du couplage par ondes évanescentes entre deux guides d'ondes est un problème connu que l'homme du métier sait résoudre. En effet, le transfert de la lumière d'un guide d'ondes à un autre guide d'ondes implique que les modes de propagation guidés de chaque guide soient suffisamment proches l'un de l'autre pour que leur partie évanescente ait un recouvrement non nul. La longueur optimale de couplage est alors fonction de ce recouvrement qui lui-même dépend des caractéristiques opto-géométriques des guides d'ondes considérés.

Par exemple, il est connu du livre intitulé Optical wave guide theory de A.W Sneider et J.D. Love publié chez Chapman and Hall, en 1983 que, pour deux guides d'ondes A et B suffisamment proches pour que la partie évanescente des modes de propagation des ondes circulant dans ces deux guides se recouvre, la longueur $L_C$ correspondant au couplage maximal depuis le guide d'ondes A vers le guide d'ondes B à l'autre peut s'écrire :

$$Lc = \frac{\pi}{\sqrt{K^2 + \delta^2}}$$

Où :

- $\delta = \frac{\pi}{\lambda}\left(n_{effA} - n_{effB}\right)$ où

  ○ $\lambda$ est la longueur dans le vide,
  ○ $n_{effA}$ est l'indice effectif du mode de propagation considéré circulant dans le guide d'ondes A , et
  ○ $n_{effB}$ est l'indice effectif du mode de propagation considéré circulant dans le guide d'ondes B,

- $K = \sqrt{\frac{\varepsilon_0}{\mu_0}} \frac{k}{4} \int_{S_B} \Delta\left(n^2\right) E_a E_b^* dA$ où

  ○ $\varepsilon_0$ est la perméabilité diélectrique dans le vide,
  ○ $\mu_0$ est la perméabilité magnétique dans le vide,
  ○ k est le nombre d'ondes associé à la longueur d'onde À,
  ○ $\Delta(n^2)$ est la différence d'indice au carré entre l'indice du coeur du guide d'ondes B et l'indice de la gaine du guide d'ondes A,
  ○ $E_a$ est le champ électrique du mode de propagation considéré dans le guide d'ondes A,
  ○ $E_b$ est le champ électrique du mode de propagation considéré dans le guide d'ondes B,
  ○ « * » désigne l'opération mathématique de conjugaison, et
  ○ $S_B$ est la section de coeur du guide d'onde des B.

Pour effectuer les calculs, l'homme du métier a usuellement recours à des outils de simulation numérique notamment pour calculer les champs des modes de propagation des guides d'ondes A et B.

Ainsi, l'homme du métier parvient à obtenir les caractéristiques de la structuration 33. La mise en oeuvre d'une telle optimisation conduit, dans le cas de la figure 1, par exemple, au choix suivant.

En outre, chaque structure 36 est agencée à la fois dans le coeur 30 et dans la gaine 32 du deuxième guide d'ondes 14.

Selon l'exemple de la figure 1, chaque lamelle 36 s'étend depuis la deuxième couche supérieure 34 en traversant l'intégralité du deuxième coeur 30 jusqu'à la deuxième couche inférieure. Plus précisément, chaque lamelle 36 présente une même dimension l36 de 3 μm selon la direction transversale X, répartis en 0,75 μm dans la deuxième couche supérieure 34, 1,5 micron dans le deuxième coeur 30 et 0,75 μm dans la deuxième couche inférieure.

De ce fait, les lamelles 36 sont en contact avec la première couche inférieure 28.

Les lamelles 36 sont réalisées en oxyde de silicium (de formule chimique $SiO_2$). L'indice n36 des lamelles 36 s'élève alors à 1,5, ce qui se traduit mathématiquement par n36 = 1,5. L'indice n36 des lamelles 36 est inférieur à l'indice effectif NF1 du premier guide d'ondes 16.

La structuration 33 présente un espacement e entre les lamelles 36 tel que la période P de la structuration 33, c'est-à-dire la somme de l'espacement e et l'épaisseur de la lamelle e36, soit inférieure ou égale au rapport de la longueur d'onde de fonctionnement du coupleur optique et du produit de deux par le deuxième indice effectif NF2. L'espacement entre les lamelles 36 est la distance séparant deux lamelles 36 le long de la direction longitudinale Z. Ceci se traduit mathématiquement par :

$$P = e + e36 \leq \frac{\lambda}{2NF2}$$

Les simulations effectuées par la demanderesse ont montré que plus la période P est faible et meilleur est le couplage.

Selon l'exemple de la figure 1, la période P entre les lamelles est strictement inférieur à 0,65 μm.

De préférence, le facteur de remplissage est compris entre 10 et 30%.

Dans l'exemple de la figure 1, le facteur de remplissage est de 14%.

Le fonctionnement du coupleur optique 10 selon l'invention est maintenant décrit.

Lorsque le premier guide d'ondes 12 est alimenté en énergie, le premier guide d'ondes 12 émet de la lumière sous forme d'ondes guidées dans le premier coeur 22.

Une partie des ondes guidées dans le premier coeur 22 se couple alors avec le deuxième guide d'ondes 16 par des ondes évanescentes. Des ondes sont alors guidées dans le deuxième coeur 30.

La structuration 33 permet de réaliser une adaptation de l'indice effectif favorisant le couplage entre le premier guide d'ondes 12 et le deuxième guide d'ondes 16.

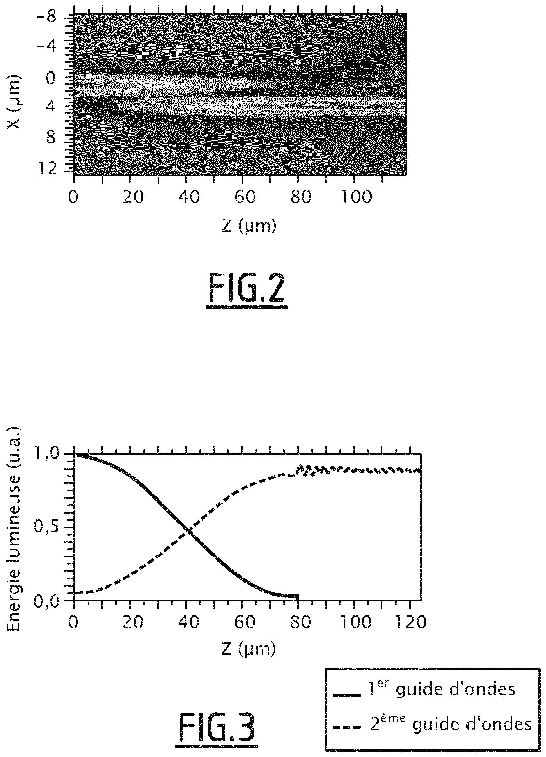

Les figures 2 et 3 sont des simulations montrant la répartition de l'énergie lumineuse dans le coupleur optique 10 selon la figure 1. A l'observation de la figure 3, il apparaît qu'au plan d'entrée 12e du premier guide d'ondes 12, l'intensité du champ électrique est de 100% alors qu'au plan de sortie 12s du deuxième guide d'ondes 14, l'intensité du champ électrique est de 80%, ce qui montre que le couplage C est de l'ordre de 80%.

Ceci montre que les paramètres choisis pour le coupleur 10 de la figure 1, c'est-à-dire pour chacune des trois couches (troisième coeur 26, couche supérieure 40 et couche inférieure 42) la dimension le long de la direction longitudinale Z de la couche considérée, la dimension le long de la direction transversale X de la couche considérée et l'indice optique dans lequel est réalisé la couche considérée, vérifient la propriété P1.

Le couplage C obtenue en étudiant la figure 3 est à comparer au couplage obtenu avec un coupleur optique selon l'état de la technique.

Un tel coupleur optique selon l'état de la technique est un coupleur représentant les mêmes caractéristiques mais dépourvu de structuration.

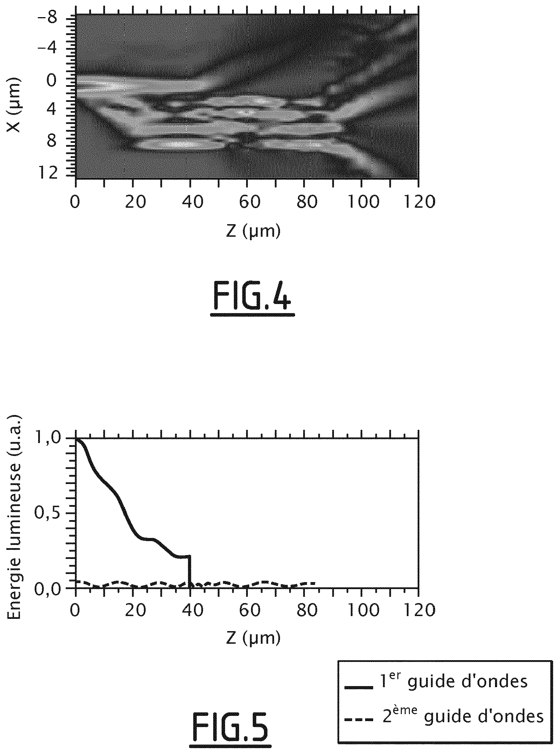

Dans ce cas, les figures 4 et 5 sont obtenues par simulation. A l'étude de la figure 5, il est constaté que le couplage C est faible, de l'ordre de 5%. Autrement formulé, l'emploi du coupleur 10 selon l'invention permet d'obtenir un gain d'un facteur 16 en termes de couplage.

Le coupleur optique 10 selon l'invention permet donc grâce à la présence de la structuration 33 de réaliser une adaptation d'indice effectif permettant d'assurer un passage d'un premier mode de propagation P1 à un deuxième mode de propagation P2 de meilleure qualité que dans l'état de la technique. Ceci conduit à l'augmentation du couplage C observé.

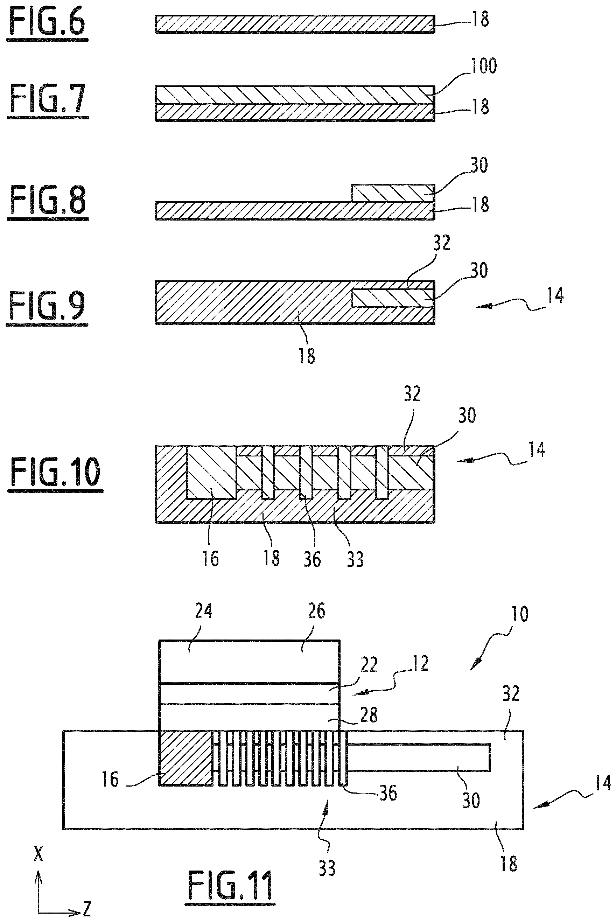

Ce meilleur couplage s'obtient tout en conservant une fabrication aisée. Pour illustrer cet avantage, il est maintenant décrit en référence aux figures 6 à 11.

Ainsi que cela apparaît à l'étude des valeurs de l'exemple de la figure 1, en l'absence du troisième guide d'ondes 14, comme l'indice ng2 de la deuxième gaine est supérieur à l'indice nc1 du premier coeur 20, le couplage est physiquement impossible. L'introduction du troisième guide d'ondes 14 permet que, pour chaque guide d'ondes, l'indice de la gaine du guide d'ondes soit inférieur aux indices du ou des coeurs de chaque guide d'ondes adjacent.

Le procédé de fabrication comporte, dans un premier temps, le dépôt d'un substrat 18 en silicium. Par exemple, l'étape de dépôt 102 est, par exemple, mise en oeuvre par une technique connue en soi de dépôt en phase vapeur chimique (souvent appelée CVD pour Chemical Vapor Déposition) ou physique en phase vapeur (souvent appelée PVD pour Physical Vapor Déposition). La couche de substrat 18 obtenue est illustrée schématiquement à la figure 6.

Le procédé de fabrication comporte ensuite la fabrication d'une couche 100 en silicium et germanium sur le substrat 18 en silicium. Selon l'exemple proposé, la fabrication est mise en oeuvre par réalisation d'une épitaxie de silicium et de germanium cristallin. L'épitaxie est une technique de croissance orientée, l'un par rapport à l'autre, de deux matériaux (en l'occurrence le silicium et le germanium) possédant un certain nombre d'éléments de symétrie communs dans leurs réseaux cristallins. L'ensemble de la couche de substrat 18 et de la couche 100 en silicium et germanium obtenu à l'issue de cette étape du procédé est illustrée schématiquement à la figure 7.

Le procédé comprend ensuite une étape de lithogravure réalisée dans la couche de silicium-germanium de manière à découper une partie de la couche 100 pour obtenir une couche formant le deuxième coeur 30 du deuxième guide d'ondes 14. L'ensemble de la couche de substrat 18 et du deuxième coeur 30 obtenu à l'issue de cette étape du procédé est illustrée schématiquement à la figure 8.

Le procédé comporte après une étape de fabrication d'une couche en silicium de manière à former la couche supérieure 32 du deuxième guide d'ondes 14. Cette étape de fabrication comporte successivement une étape d'épitaxie de la couche et une étape de polissage de la couche pour planariser la surface. Selon l'exemple de procédé illustré, l'étape de polissage est mise en oeuvre à l'aide d'une technique de polissage mécano-chimique, plus souvent désignée par son acronyme CMP pour l'anglais « Chemical Mechanical Polishing ». L'ensemble du substrat 18 et du deuxième guide d'ondes 14 obtenu à l'issue de cette étape du procédé est illustrée schématiquement à la figure 9.

Le procédé comporte ensuite une étape de fabrication de la structuration 33 comprenant une sous-étape de lithogravure permettant de réaliser des trous dans le deuxième guide d'ondes 14, ces trous étant ensuite remplis par le matériau formant les lamelles 36, en l'occurrence de l'oxyde de silicium. La sous-étape de lithogravure est suivie d'une nouvelle sous-étape de polissage. L'ensemble du substrat 18 et du deuxième guide d'ondes 14 muni de la structuration 33 obtenu à l'issue de cette étape du procédé est illustrée schématiquement à la figure 10.

Le procédé comporte enfin une étape de collage du premier guide d'ondes 12, dont le résultat est illustré par la figure 11.L'étape de collage pourra être un collage par adhésion moléculaire. On peut aussi réaliser un collage de l'épitaxie simple (couches minces), puis réalisation du guide d'ondes 12 par les techniques semblables à celles utilisées pour le guide d'ondes 14.

Le procédé permet donc d'obtenir le coupleur optique 10. La mise en oeuvre de ce procédé implique uniquement des technologies éprouvées dans le cadre de la fabrication des composants planaires, et plus particulièrement les composants en matériau semi-conducteur. Notamment, un tel procédé de fabrication n'implique pas la mise en oeuvre d'une technologie d'immersion dans des bains de sels fondus qui est une technologie délicate à mettre en oeuvre. De ce fait, le procédé selon l'invention est particulièrement aisé à mettre en oeuvre.

En outre, le coupleur optique 10 présente l'avantage de ne pas imposer de contraintes sur la forme du premier guide d'ondes 12 et du deuxième guide d'ondes 14. Le premier guide d'ondes 12 et le deuxième guide d'ondes 14 peuvent donc être optimisés pour fournir un rendement optimal (rapport entre la puissance en sortie du dispositif considéré et la puissance incidente sur le dispositif considéré) sans dégrader le couplage C.

En variante, il est à noter qu'il est possible de concevoir de multiples coupleurs optiques 10 dont les paramètres de la structuration 33 vérifient la propriété P1 relative au couplage C.

Notamment, différents matériaux sont envisageables pour réaliser la structuration 33. En particulier, des matériaux semi-conducteurs de type « III - V » sont envisageables.

Ces remarques sur les matériaux s'appliquent aux matériaux de toutes les couches intervenant dans le coupleur 10.

A titre d'illustration, il est considéré un coupleur 10 selon un deuxième mode de réalisation. Les éléments identiques entre le coupleur 10 selon le deuxième mode de réalisation et le coupleur 10 selon le premier mode de réalisation ne sont pas répétés. Seules les différentes sont mises en évidence.

Dans ce cas, les lamelles 36 sont en sulfure de zinc (de formule chimique ZnS). L'indice n36 vaut dans ce cas 2,25, ce qui se traduit mathématiquement par n36 = 2,25. De plus, le facteur de remplissage est de 23%.

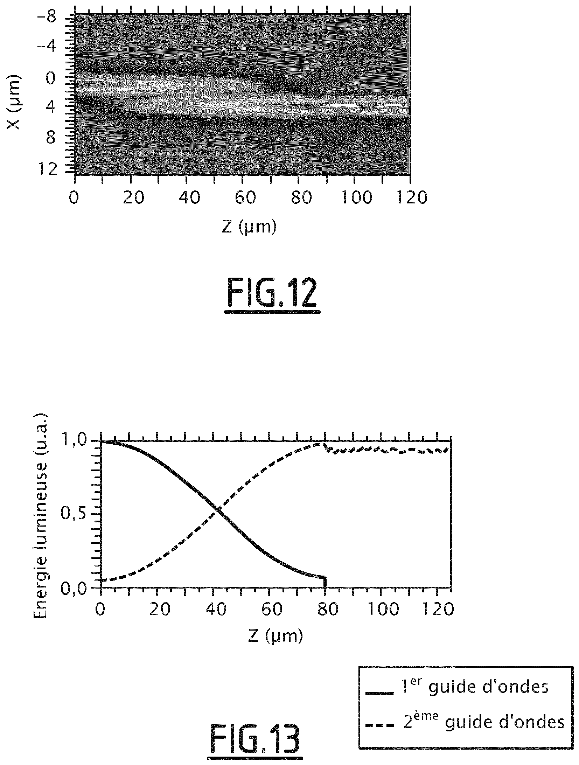

Les figures 12 et 13 sont des simulations montrant la répartition de l'énergie lumineuse dans le coupleur optique 10 selon le deuxième mode de réalisation. A l'observation de la figure 13, il apparaît que l'intensité du champ électrique est de 100% dans le plan d'entrée 12e du premier guide d'ondes 12 alors que dans le plan de sortie 14s du deuxième guide d'ondes 14, l'intensité du champ électrique est de 80%, ce qui montre que le couplage C est de l'ordre de 80%.

Cet exemple illustre également que de préférence, pour obtenir le meilleur couplage, les paramètres caractérisant la structuration 33 vérifient, en variante, une deuxième propriété notée P2. La deuxième propriété P2 est vérifiée lorsque le couplage C par ondes évanescentes entre le premier guide d'ondes 12 et le deuxième guide d'ondes 14 est supérieur à 30%.

Encore plus avantageusement, en variante, les paramètres caractérisant la structuration 33 vérifient une troisième propriété notée P3. La troisième propriété P3 est vérifiée lorsque le couplage C par ondes évanescentes entre le premier guide d'ondes 12 et le deuxième guide d'ondes 14 est supérieur à 50%.

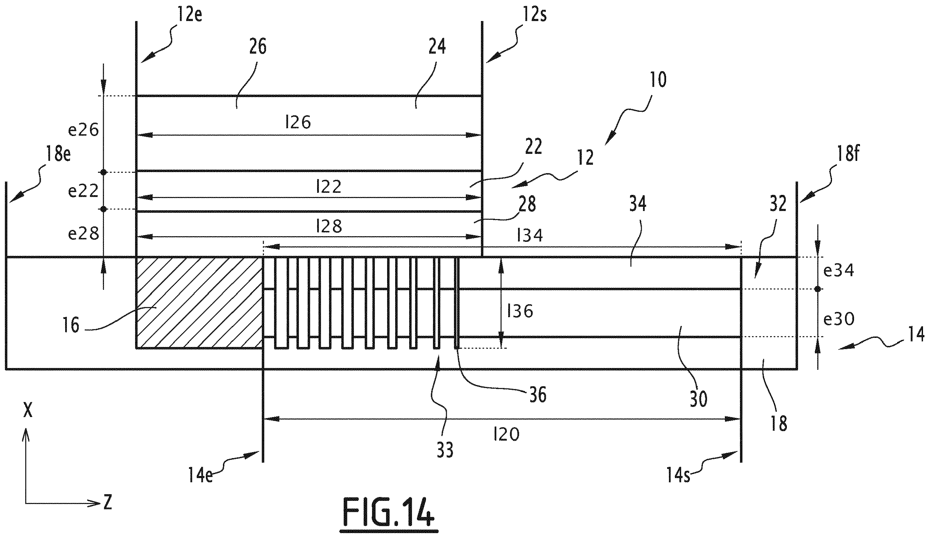

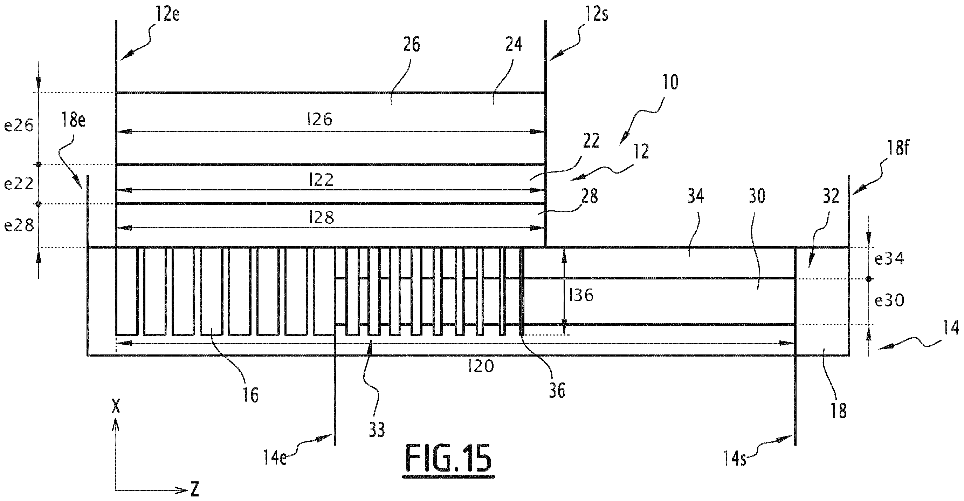

D'autres structures plus complexes sont également avantageuses pour le coupleur optique 10. Les figures 14 et 15 en illustrent deux exemples.

La figure 14 montre un coupleur optique 10 selon un troisième mode de réalisation. Les éléments identiques entre le coupleur 10 selon le troisième mode de réalisation et le coupleur 10 selon le premier mode de réalisation ne sont pas répétés. Seules les différences sont mises en évidence.

Dans ce troisième mode de réalisation, la dimension e36 le long de la direction longitudinale Z de chaque lamelle varie. Plus précisément, selon le sens de propagation de la lumière, la dimension e36 le long de la direction longitudinale Z d'une lamelle est plus faible que la dimension e36 le long de la direction longitudinale Z de la lamelle précédente.

Cela permet d'obtenir une structuration 33 assurant un couplage adiabatique des ondes. De ce fait, le facteur de remplissage passe d'une valeur minimale à une valeur maximale, en passant par la valeur de couplage résonant mentionné dans le précédent mode de réalisation. Si cette variation est suffisamment lente, on obtient un couplage optimal, équivalent à celui du couplage par la structuration périodique du précédent mode de réalisation. L'intérêt principal est la robustesse aux imperfections technologiques. En effet, pour un facteur de remplissage bien particulier visé, il est possible que la fabrication technologique de structuration 33 ne soit pas parfaite, ceci entraînant que le couplage sera mauvais. Avec un gradient de facteur de remplissage, en étant donc sûr de passer par la bonne valeur, alors le couplage est assuré.

La figure 15 montre un coupleur optique 10 selon un quatrième mode de réalisation. Les éléments identiques entre le coupleur 10 selon le quatrième mode de réalisation et le coupleur 10 selon le troisième mode de réalisation ne sont pas répétés. Seules les différences sont mises en évidence.

Dans le cas de la figure 15, il est supposé que la conductivité thermique du matériau dans lequel est réalisé l'élément d'isolation 16 est inférieure à celle du substrat 18. Pour améliorer la conductivité thermique, il est proposé que l'élément d'isolation 16 soit pourvu d'ouvertures ou se présente sous forme de lamelles comme la structuration 33 pour bénéficier des meilleures propriétés d'évacuation de la chaleur du substrat 18.

Selon d'autres variantes, il est également possible de considérer des structures plus complexes. A titre d'exemple, le coupleur optique 10 comporte un troisième guide d'ondes distinct des premier et deuxième guides d'ondes 12, 14 et s'étendant parallèlement aux premier et deuxième guides d'ondes 12, 14, le troisième guide d'ondes étant agencé entre le premier guide d'ondes 12 et le deuxième guide d'ondes 14 et étant propre à propager un troisième mode de propagation P3 de lumière présentant un troisième indice effectif NF3.

Dans ce cas, c'est l'ensemble des paramètres caractérisant les troisième guide d'ondes et la structuration 33 qui sont tels que le couplage par ondes évanescentes entre le premier guide d'ondes 12 et le deuxième guide d'ondes 14 soit supérieur à 15% (respectivement 30%, 50% selon la propriété choisie).

Du fait de la multiplicité des coupleurs optiques 10 répondant aux propriétés P1, P2 ou P3, il est également proposé, dans le cadre de cette invention, un procédé de détermination des paramètres comportant une étape de choix des paramètres de sorte que le couplage C soit supérieur à 15%, 30% ou 50%.

Le coupleur optique 10 obtenu est notamment particulièrement intéressant dans le cas d'un capteur de gaz intégrés. Plus généralement, un tel coupleur optique 10 peut être utilisé dans tout composant optique pour lequel il est favorable de mettre en oeuvre une intégration hétérogène.

Il est aussi à noter que le coupleur optique 10 trouve également des applications dans le cas où le premier guide d'ondes 12 n'est pas un guide d'ondes actif. A titre d'exemple, le premier guide d'ondes 12 est un détecteur infrarouge comprenant un matériau absorbant à la longueur d'onde d'intérêt avec un guide d'ondes 14 transparent à cette même longueur d'onde d'intérêt, Ainsi, on vient détecter avec le guide 12 la lumière provenant du guide 14 en sens inverse.

Le coupleur optique 10 proposé concerne surtout le domaine de l'infrarouge moyen.

Il est entendu par « infrarouge moyen » une bande spectrale regroupant les ondes dont la longueur d'onde est comprise entre 2 $\mu$m et 10 $\mu$m.

De préférence, la bande spectrale précédente est limitée à la bande comprise entre 2 $\mu$m et 7 $\mu$m, notamment si du SiO2 est utilisé car le SiO2 présente une forte absorption pour des rayonnements dont la longueur d'onde est supérieure à 7 $\mu$m.

En particulier, dans le cas où le deuxième guide d'ondes est en un Si (gaine) / SiGe(coeur) ou en SiGe (gaine) / Ge (coeur), un problème de fuite du champ laser apparait dès que l'indice nc1 du premier coeur 22 est inférieur à l'indice optique ng2 de la deuxième gaine 32. La structuration 33 permet de limiter cette fuite.

Il est à noter que pour un rayonnement en deçà de 2 $\mu$m le problème de fuite est généralement absent puisque l'indice nc1 du premier coeur 22 est supérieur à l'indice optique ng2 de la deuxième gaine 32.

De plus, il est également à noter que la zone de couplage du coupleur 10 présente un indice effectif.

Lorsque l'indice effectif de la zone de couplage du coupleur 10 est constant, l'indice effectif de la zone de couplage est tel que l'indice optique de la deuxième gaine avec structuration 33 soit inférieur au premier indice effectif NF1 (pour éviter la fuite du mode dans la gaine). Ainsi, l'indice optique de la zone de couplage est, par exemple, inférieur ou de préférence égal au premier indice effectif NF1.

Lorsque l'indice effectif de la zone de couplage n'est pas constant, l'indice effectif varie graduellement d'une valeur inférieure ou égale au premier indice effectif NF1 jusqu'à une valeur égale au deuxième indice effectif NF1. Dans la zone de couplage, la condition selon laquelle l'indice optique de la deuxième gaine avec structuration 33 est inférieur au premier indice effectif NF1 est respectée pour éviter la fuite du mode dans la gaine. Au-delà de la zone de couplage, la lumière se propageant est essentiellement contenue dans un ou plusieurs modes guidés par le deuxième guide d'ondes. De ce fait, la condition selon laquelle l'indice optique de la deuxième gaine avec structuration 33 est inférieur au premier indice effectif NF1 peut ne plus être respectée et ce non-respect n'engendre pas de fuite.

**Revendications**

1. Coupleur optique (10) dans une configuration verticale, propre à fonctionner pour une longueur d'onde (λ) et comprenant :

   - un premier guide d'ondes (12) s'étendant selon une direction longitudinale (Z) et propre à propager un premier mode de propagation (P1) de la lumière présentant un premier indice effectif (NF1),
   - un deuxième guide d'ondes (14) distinct du premier guide d'ondes (12), parallèle au premier guide d'ondes (12), présentant un coeur (30) et une gaine (32) et propre à propager un deuxième mode de propagation (P2) de la lumière présentant un deuxième indice effectif (NF2), le deuxième indice effectif (NF2) étant différent du premier indice effectif (NF1),
   le coupleur optique (10) comportant un substrat (18), formé dans un premier matériau, dans lequel le deuxième guide d'ondes (14) est enfoui, le premier guide d'ondes (12) étant agencé en contact avec le substrat (18) et formé dans un matériau différent du premier matériau, le deuxième guide d'ondes (14) présentant une structuration (33), la structuration (33) étant sous forme d'une succession de structures (36), les structures (36) s'étendant selon le long d'une direction transversale (X) perpendiculaire à la direction longitudinale (Z), étant parallèles entre elles et orthogonales à la direction générale du premier guide d'ondes (12), le coupleur optique (10) étant **caractérisé en ce que** la structuration (33) présente une période (P) le long de la direction longitudinale (Z) inférieure au rapport entre la longueur d'onde (λ) à laquelle est propre à fonctionner le coupleur optique (10) et le produit de deux par le deuxième indice effectif (NF2), chaque structure (36) est agencée à la fois dans le coeur (30) et la gaine (32) du deuxième guide d'ondes (14), chaque structure (36) présentant des paramètres influant sur le couplage (C) par ondes évanescentes entre le premier guide d'ondes (12) et le deuxième guide d'ondes (14) à la longueur d'onde (λ) à laquelle le coupleur optique (10) est propre à fonctionner, ces paramètres étant choisis de sorte que le couplage (C) soit supérieur à 15%,

2. Coupleur optique selon la revendication 1, dans lequel les structures (36) sont choisies dans le groupe constitué par :

   - des ouvertures réalisées dans le deuxième guide d'ondes (14) et
   - des lamelles (36).

3. Coupleur optique selon la revendication 1 ou 2, dans lequel les structures (36) présentent une dimension le long de la direction transversale (X) supérieure à la dimension du coeur (30) du deuxième guide d'ondes (14) le long de la direction transversale (X).

4. Coupleur optique selon l'une des revendications 1 à 3, dans lequel le coeur (30) du deuxième guide d'ondes (14) présentant un indice optique, le deuxième indice effectif (NF2) est supérieur au premier indice effectif (NF1) et les structures (36) sont réalisées dans un matériau présentent un indice optique inférieur à l'indice optique du coeur (30) du deuxième guide d'onde (14).

5. Coupleur optique selon l'une quelconque des revendications 1 à 4, dans lequel la structuration (33) présente un facteur de remplissage (F), les structures (36) sont réalisées dans un matériau présentant un indice optique, lesdits paramètres influant sur le couplage (C) par ondes évanescentes entre le premier guide d'ondes (12) et le deuxième guide d'ondes (14) étant le facteur de remplissage de la structuration (33), l'indice optique du matériau dans lequel les structures (36) sont réalisées et l'espacement (e) le long de la direction longitudinale (Z) entre chaque structure (36).

6. Coupleur optique selon l'une quelconque des revendications 1 à 5, dans lequel chaque guide d'ondes (12, 14) comporte une gaine (24, 32) et un coeur (20, 30), l'indice optique du coeur (20) du premier guide d'ondes (12) étant inférieur à l'indice optique de la gaine (32) du deuxième guide d'ondes (14).

7. Coupleur optique selon l'une quelconque des revendications 1 à 6, dans lequel l'espacement (e) le long de la direction longitudinale (Z) entre les structures (36) est variable le long de la direction longitudinale (Z).

8. Coupleur optique selon l'une quelconque des revendications 1 à 7, dans lequel le premier guide d'ondes (12) comporte un coeur (22) réalisé dans un matériau appartenant à la colonne III du tableau périodique composé avec un matériau selon la colonne V du tableau périodique et deux couches inférieure (26) et supérieure (28) entourant le coeur (20).

9. Coupleur optique selon l'une quelconque des revendications 1 à 8, dans lequel le coeur (30) du deuxième guide d'ondes (14) présente une dimension variable le long de la direction transversale (X).

10. Coupleur optique selon l'une quelconque des revendications 1 à 9, dans lequel le coupleur optique (10) comporte un troisième guide d'ondes distinct des premier et deuxième guides d'ondes (12, 14) et s'étendant parallèlement aux premier et deuxième guides d'ondes (12, 14), le troisième guide d'ondes étant agencé entre le premier guide d'ondes (12) et le deuxième guide d'ondes (14) et étant propre à propager un troisième mode de propagation (P3) de lumière présentant un troisième indice effectif (NF3).

11. Coupleur optique selon l'une quelconques des revendications 1 à 10, comportant une zone d'isolation thermique du premier guide d'ondes (12) dans laquelle la structuration (33) est agencée.

12. Composant optique comprenant un coupleur optique (10) selon l'une quelconque des revendications 1 à 11.

13. Procédé de détermination d'un coupleur optique (10) dans une configuration verticale, propre à fonctionner pour une longueur d'onde (À) et comprenant :

- un premier guide d'ondes (12) s'étendant selon une direction longitudinale (Z) et propre à propager un premier mode de propagation (P1) de la lumière présentant un premier indice effectif (NF1),
- un deuxième guide d'ondes (14) distinct du premier guide d'ondes (12), parallèle au premier guide d'ondes (12), présentant un coeur (30) et une gaine (32) et propre à propager un deuxième mode de propagation (P2) de la lumière présentant un deuxième indice effectif (NF2), le deuxième indice effectif (NF2) étant supérieur au premier indice effectif (NF1), le deuxième guide d'ondes (14) présentant une structuration (33), la structuration (33) présentant une période (P) le long de la direction longitudinale (Z) inférieure au rapport entre la longueur d'onde (À) à laquelle est propre à fonctionner le coupleur optique (10) et le produit de deux par le deuxième indice effectif (NF2), la structuration (33) étant sous forme d'une succession de structures (36) présentant des paramètres influant sur le couplage par ondes évanescentes entre le premier guide d'ondes (12) et le deuxième guide d'ondes (14), les structures (36) s'étendant selon le long d'une direction transversale (X) perpendiculaire à la direction longitudinale (Z), étant parallèles entre elles et orthogonales à la direction générale du premier guide d'onde (12), chaque structure (36) est agencée à la fois dans le coeur (30) et la gaine (32) du deuxième guide d'ondes (14), chaque structure (36) présentant des paramètres influant sur le couplage par ondes évanescentes entre le premier guide d'ondes (12) et le deuxième guide d'ondes (14) à la longueur d'onde (λ) à laquelle le coupleur optique (10) est propre à fonctionner, le coupleur optique (10) comportant un substrat (18), formé dans un premier matériau, dans lequel le deuxième guide d'ondes (14) est enfoui, le premier guide d'ondes (12) étant agencé en contact avec le substrat (18) et formé dans un matériau différent du premier matériau,

le procédé étant **caractérisé en ce que** le procédé comprend une étape de :

- choix d'un couplage désiré par ondes évanescentes entre le premier guide d'ondes (12) et le deuxième guide d'ondes (14), le couplage désiré étant supérieur ou égal à 15%,
- modification des paramètres de la structuration (33) pour obtenir le couplage par ondes évanescentes entre le premier guide d'ondes (12) et le deuxième guide d'ondes (14) désiré.

14. Procédé de fabrication d'un coupleur optique (10) selon l'une quelconque des revendications 1 à 11, dans lequel le procédé de fabrication comprend des étapes de fabrication des guides d'ondes (12, 14) et de la structuration (33) impliquant des techniques de dépôt, d'épitaxie, de polissage, de collage et d'enlèvement de matière par gravure.

**Patentansprüche**

1. Optischer Koppler (10) in einer vertikalen Konfiguration, der imstande ist, für eine Wellenlänge (λ) zu funktionieren, und welcher aufweist:

- einen ersten Wellenleiter (12), der sich entlang einer longitudinalen Richtung (Z) erstreckt und imstande ist, eine Ausbreitungsmode (P1) des Lichtes zu übertragen, und der einen ersten effektiven Index (NF1) hat,
- einen zweiten Wellenleiter (14), der verschieden ist von dem ersten Wellenleiter (12), der parallel zu dem ersten Wellenleiter (12) ist, der einen Kern (30) und eine Hülle (32) hat und imstande ist, eine zweite Ausbreitungsmode (P2) des Lichtes zu übertragen, und der einen zweiten effektiven Index (NF2) hat, wobei der zweite effektive Index (NF2) verschieden von dem ersten effektiven Index (NF1) ist, wobei der optische Koppler (10) ein Substrat (18) aufweist, welches aus einem ersten Material gebildet ist, in welchem der zweite Wellenleiter (14) untergebracht ist, wobei der erste Wellenleiter (12) in Kontakt mit dem Substrat (18) angeordnet und aus einem Material gebildet ist, welches verschieden von dem ersten Material ist, wobei der zweite Wellenleiter (14) eine Strukturierung (33) hat, wobei die Strukturierung (33) in Form einer Aufeinanderfolge von Strukturen (36) ist, wobei sich die Strukturen (36) entlang einer transversalen Richtung (X) erstrecken, die senkrecht zu der longitudinalen Richtung (Z) ist, und parallel zueinander und senkrecht zu der allgemeinen Richtung des ersten Wellenleiters (12) sind,

wobei der optische Koppler (10) **dadurch gekennzeichnet ist, dass** die Strukturierung (33) eine Periodenlänge (P) entlang der longitudinalen Richtung (Z) hat, die kleiner ist als das Verhältnis zwischen der Wellenlänge (λ), bei welcher der optische Koppler (10) zu funktionieren imstande ist, und dem Produkt von zwei mit dem zweiten effektiven Index (NF2), wobei jede Struktur (36) gleichzeitig in dem Kern (30) und der Hülle (32) des zweiten Wellenleiters (14) angeordnet ist, wobei jede Struktur (36) Parameter hat, welche die Kopplung (C) mittels evaneszenter Wellen zwischen dem ersten Wellenleiter (12) und dem zweiten Wellenleiter (14) bei der Wellenlänge (λ), bei welcher der optische Koppler (10) zu funktionieren imstande ist, beeinflussen, wobei diese Parameter so ausgewählt sind, dass die Kopplung (C) größer als 15% ist.

2. Optischer Koppler gemäß Anspruch 1, wobei die Strukturen (36) ausgewählt sind aus der Gruppe, die gebildet ist aus:

   - Öffnungen, welche in dem zweiten Wellenleiter (14) realisiert sind, und
   - Lamellen (36).

3. Optischer Koppler gemäß Anspruch 1 oder 2, wobei die Strukturen (36) eine Abmessung entlang der transversalen Richtung (X) haben, die größer ist als die Abmessung des Kerns (30) des zweiten Wellenleiters (14) entlang der transversalen Richtung (X).

4. Optischer Koppler gemäß einem der Ansprüche 1 bis 3, wobei der Kern (30) des zweiten Wellenleiters (14) einen Brechungsindex hat, der zweite effektive Index (NF2) größer ist als der erste effektive Index (NF1) und die Strukturen (36) aus einem Material realisiert sind, welches einen Brechungsindex hat, der kleiner ist als der Brechungsindex des Kerns (30) des zweiten Wellenleiters (14).

5. Optischer Koppler gemäß irgendeinem der Ansprüche 1 bis 4, wobei die Strukturierung (33) einen Füllfaktor (F) hat, die Strukturen (36) aus einem Material realisiert sind, welches einen Brechungsindex hat, wobei die besagten Parameter, welche die Kopplung (C) mittels evaneszenter Wellen zwischen dem ersten Wellenleiter (12) und dem zweiten Wellenleiter (14) beeinflussen, der Füllfaktor der Strukturierung (33), der Brechungsindex des Materials, aus welchem die Strukturen (36) realisiert sind, und der Abstand (e) entlang der longitudinalen Richtung (Z) zwischen jeder Struktur (36) sind.

6. Optischer Koppler gemäß irgendeinem der Ansprüche 1 bis 5, wobei jeder Wellenleiter (12, 14) eine Hülle (24, 32) und einen Kern (20, 30) aufweist, wobei der Brechungsindex des Kerns (20) des ersten Wellenleiters (12) kleiner ist als der Brechungsindex der Hülle (32) des zweiten Wellenleiters (14).

7. Optischer Koppler gemäß irgendeinem der Ansprüche 1 bis 6, wobei der Abstand (e) entlang der longitudinalen Richtung (Z) zwischen den Strukturen (36) variabel ist entlang der longitudinalen Richtung (Z).

8. Optischer Koppler gemäß irgendeinem der Ansprüche 1 bis 7, wobei der erste Wellenleiter (12) aufweist einen Kern (22), der aus einem Material realisiert ist, welches zu der Spalte III des Periodensystems gehört, zusammengesetzt mit einem Material gemäß der Spalte V des Periodensystems, und zwei Schichten, eine untere (26) und eine obere (26), welche den Kern (20) umgeben.

9. Optischer Koppler gemäß irgendeinem der Ansprüche 1 bis 8, wobei der Kern (30) des zweiten Wellenleiters (14) eine Abmessung hat, die variabel entlang der transversalen Richtung (X) ist.

10. Optischer Koppler gemäß irgendeinem der Ansprüche 1 bis 9, wobei der optische Koppler (10) einen dritten Wellenleiter aufweist, der verschieden von dem ersten und dem zweiten Wellenleiter (12, 14) ist und sich parallel zu dem ersten und dem zweiten Wellenleiter (12, 14) erstreckt, wobei der dritte Wellenleiter zwischen dem ersten Wellenleiter (12) und dem zweiten Wellenleiter (14) angeordnet ist und imstande ist, eine dritte Ausbreitungsmode (P3) von Licht zu übertragen, und der einen dritten effektiven Index (NF3) hat.

11. Optischer Koppler gemäß irgendeinem der Ansprüche 1 bis 10, welcher eine Zone zur thermischen Isolation des ersten Wellenleiters (12) aufweist, in welcher die Strukturierung (33) angeordnet ist.

12. Optische Komponente, welche einen optischen Koppler (10) gemäß irgendeinem der Ansprüche 1 bis 11 aufweist.

13. Verfahren zum Ermitteln mit einem optischen Koppler (10) in einer vertikalen Konfiguration, welcher imstande ist, für eine Wellenlänge (λ) zu funktionieren, und welcher aufweist:

   - einen ersten Wellenleiter (12), der sich entlang einer longitudinalen Richtung (Z) erstreckt und imstande ist, eine Ausbreitungsmode (P1) des Lichtes zu übertragen, und der einen ersten effektiven Index (NF1) hat,

- einen zweiten Wellenleiter (14), der verschieden ist von dem ersten Wellenleiter (12), der parallel zu dem ersten Wellenleiter (12) ist, der einen Kern (30) und eine Hülle (32) hat und imstande ist, eine zweite Ausbreitungsmode (P2) des Lichtes zu übertragen, und der einen zweiten effektiven Index (NF2) hat, wobei der zweite effektive Index (NF2) größer als der erste effektive Index (NF1) ist, wobei der zweite Wellenleiter (14) eine Strukturierung (33) hat, wobei die Strukturierung (33) eine Periodenlänge (P) entlang der longitudinalen Richtung (Z) hat, die kleiner ist als das Verhältnis zwischen der Wellenlänge (λ), bei welcher der optische Koppler (10) zu funktionieren imstande ist, und dem Produkt von zwei mit dem zweiten effektiven Index (NF2), wobei die Strukturierung (33) in Form einer Aufeinanderfolge von Strukturen (36) ist, welche Parameter hat, welche die Kopplung mittels evaneszenter Wellen zwischen dem ersten Wellenleiter (12) und dem zweiten Wellenleiter (14) beeinflussen, wobei sich die Strukturen (36) entlang einer transversalen Richtung (X) erstrecken, die senkrecht zu der longitudinalen Richtung (Z) ist, und parallel zueinander und senkrecht zu der allgemeinen Richtung des ersten Wellenleiters (12) sind, wobei jede Struktur (36) gleichzeitig in dem Kern (30) und der Hülle (32) des zweiten Wellenleiters (14) angeordnet ist, wobei jede Struktur (36) Parameter hat, welche die Kopplung mittels evaneszenter Wellen zwischen dem ersten Wellenleiter (12) und dem zweiten Wellenleiter (14) bei der Wellenlänge (λ), bei welcher der optische Koppler (10) zu funktionieren imstande ist, beeinflussen, wobei der optische Koppler (10) ein Substrat (18) aufweist, welches aus einem ersten Material gebildet ist, in welchem der zweite Wellenleiter (14) untergebracht ist, wobei der erste Wellenleiter (12) in Kontakt mit dem Substrat (18) angeordnet und aus einem Material gebildet ist, welches verschieden von dem ersten Material ist,

wobei das Verfahren **dadurch gekennzeichnet ist, dass** das Verfahren einen der folgenden Schritte aufweist:

- Auswählen einer gewünschten Kopplung mittels evaneszenter Wellen zwischen dem ersten Wellenleiter (12) und dem zweiten Wellenleiter (14), wobei die gewünschte Kopplung größer oder gleich 15% ist,
- Modifizieren der Parameter der Strukturierung (33), um die gewünschte Kopplung mittels evaneszenter Wellen zwischen dem ersten Wellenleiter (12) und dem zweiten Wellenleiter (14) zu erlangen.

14. Verfahren zum Herstellen eines optischen Kopplers (10) gemäß irgendeinem der Ansprüche 1 bis 11, wobei das Verfahren zum Herstellen Schritte des Herstellen der Wellenleiter (12, 14) und der Strukturierung (33) aufweist, welches Abscheidungs-, Epitaxie, Politur-, Klebe- und Entfernen-von-Material-mittels-Ätzens-Techniken enthält.

**Claims**

1. An optical coupler (10) in a vertical configuration, capable of working for a wavelength (A) and comprising:

- a first waveguide (12) extending in the longitudinal direction (Z) and capable of propagating a first propagation mode (P1) of the light having a first effective index (NF1),
- a second waveguide (14) distinct from the first waveguide (12), parallel to the first waveguide (12), having a core (30) and a cladding (32) and capable of propagating a second propagation mode (P2) of the light having a second effective index (NF2), the second effective index (NF2) being different from the first effective index (NF1),

the optical coupler (10) including a substrate (18), made from a first material, in which the second waveguide (14) is buried, the first waveguide (12) being arranged in contact with the substrate (18) and formed from a material different from the first material,

the second waveguide (14) having a patterning (33), the patterning (33) being in the form of a series of patterns (36), the patterns (36) extending along a transverse direction (X) perpendicular to the longitudinal direction (Z), being parallel to each other and orthogonal to the general direction of the first waveguide (12),

the optical coupler (10) being **characterized in that** the patterning (33) has a period (P) along the longitudinal direction (Z) below the ratio between the wavelength (A) at which the optical coupler (10) is capable of operating and the product of two by the second effective index (NF2), each pattern (36) is arranged both in the core (30) and the cladding (32) of the second waveguide (14), each pattern (36) having parameters influencing the evanescent wave coupling (C) between the first waveguide (12) and the second waveguide (14) at the wavelength (A) at which the optical coupler (10) is capable of operating, said parameters being chosen such that the coupling (C) is greater than 15%.

**2.** The optical coupler according to claim 1, wherein the patterns (36) are chosen from the group made up of:

- openings made in the second waveguide (14), and
- blades (36).

**3.** The optical coupler according to claim 1 or 2, wherein the patterns (36) have a dimension along the transverse direction (X) larger than the dimension of the core (30) of the second waveguide (14) along the transverse direction (X).

**4.** The optical coupler according to one of claims 1 to 3, wherein the core (30) of the second waveguide (14) having an optical index, the second effective index (NF2) is greater than the first effective index (NF1) and the patterns (36) are made from a material having an optical index below the optical index of the core (30) of the second waveguide (14).

**5.** The optical coupler according to any one of claims 1 to 4, wherein the patterning (33) has a fill factor (F), the patterns (36) are made from a material having an optical index, the parameters influencing the evanescent wave coupling (C) between the first waveguide (12) and the second waveguide (14) being the fill factor of the patterning (33), the optical index of the material from which the patterns (36) are made, and the spacing (e) along the longitudinal direction (Z) between each pattern (36).

**6.** The optical coupler according to any one of claims 1 to 5, wherein each waveguide (12, 14) includes a cladding (24, 32) and a core (20, 30), the optical index of the core (20) of the first waveguide (12) being below the optical index of the cladding (32) of the second waveguide (14).

**7.** The optical coupler according to any one of claims 1 to 6, wherein the spacing (e) along the longitudinal direction (Z) between the patterns (36) is variable in the longitudinal direction (Z).

**8.** The optical coupler according to any one of claims 1 to 7, wherein the first waveguide (12) includes a core (22) made from a material belonging to column III of the periodic table formed with a material from column V of the periodic table and two lower (26) and upper (28) layers surrounding the core (20).

**9.** The optical coupler according to any one of claims 1 to 8, wherein the core (30) of the second waveguide (14) has a variable dimension in the transverse direction (X).

**10.** The optical coupler according to any one of claims 1 to 9, wherein the optical coupler (10) includes a third waveguide distinct from the first and second waveguides (12, 14) and extending parallel to the first and second waveguides (12, 14), the third waveguide being arranged between the first waveguide (12) and the second waveguide (14) and being capable of propagating a third light propagation mode (P3) having a third effective index (NF3).

**11.** The optical coupler according to any one of claims 1 to 10, including a thermal insulation zone of the first waveguide (12) in which the patterning (33) is arranged.

**12.** An optical component comprising an optical coupler (10) according to any one of claims 1 to 11.

**13.** A method for determining an optical coupler (10) in a vertical configuration, capable of working for a wavelength (λ) and comprising:

- a first waveguide (12) extending in the longitudinal direction (Z) and capable of propagating a first propagation mode (P1) of the light having a first effective index (NF1),
- a second waveguide (14) distinct from the first waveguide (12), parallel to the first waveguide (12), having a core (30) and a cladding (32) and capable of propagating a second propagation mode (P2) of the light having a second effective index (NF2), the second effective index (NF2) being greater than the first effective index (NF1), the second waveguide (14) having a patterning (33), the patterning (33) having a period (P) along the longitudinal direction (Z) below the ratio between the wavelength (A) at which the optical coupler (10) is capable of operating and the product of two by the second effective index (NF2), the patterning (33) being in the form of a series of patterns (36) having parameters influencing the evanescent wave coupling between the first waveguide (12) and the second waveguide (14), the patterns (36) extending along a transverse direction (X) perpendicular to the longitudinal direction (Z), being parallel to each other and orthogonal to the general direction of the first waveguide (12), each pattern (36) is arranged both in the core (30) and the cladding (32) of the second waveguide (14), each pattern (36) having parameters influencing the evanescent wave coupling (C) between the first waveguide (12) and the second waveguide (14) at the wavelength (A) at which the optical coupler (10) is capable of operating, the optical coupler (10) including a substrate (18), made from a first material, in which the second waveguide (14) is buried, the first waveguide (12) being arranged in contact with the substrate (18) and formed from a material different from the first material,

the method being **characterized in that** the method comprises a step for:

- choosing a desired evanescent wave coupling between the first waveguide (12) and the second waveguide (14), the desired coupling being greater than or equal to 15%,
- modifying the parameters of the patterning (33) to obtain the desired evanescent wave coupling between the first waveguide (12) and the second waveguide (14).

14. A method for manufacturing an optical coupler (10) according to any one of claims 1 to 11, wherein the manufacturing method comprises steps for manufacturing waveguides (12, 14) and the patterning (33) involving techniques for deposition, epitaxy, polishing, gluing and material removal by etching.

FIG.1

## FIG.2

## FIG.3

| | |
|---|---|
| —— | 1er guide d'ondes |
| - - - | 2ème guide d'ondes |

EP 3 022 594 B1

**FIG.4**

**FIG.5**

| | |
|---|---|
| —— | 1$^{er}$ guide d'ondes |
| - - - | 2$^{ème}$ guide d'ondes |

19

FIG.6

FIG.7

FIG.8

FIG.9

FIG.10

FIG.11

## FIG.12

__ 1$^{er}$ guide d'ondes

--- 2$^{ème}$ guide d'ondes

## FIG.13

FIG.14

FIG.15

EP 3 022 594 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 03054596 A
- FR 2909491 A
- WO 0244780 A
- US 20110299561 A
- US 2011194804 A1

**Littérature non-brevet citée dans la description**

- **BOCK et al.** *Subwavelength grating periodic structures in silicon-on-insulator : a new type of microphonic waveguide*
- **A.W SNEIDER ; J.D. LOVE.** Optical wave guide theory. Chapman and Hall, 1983